# EUROPÄISCHE PATENTANMELDUNG

(11) **EP 0 753 754 A2**
(43) Veröffentlichungstag der Anmeldung: **15.01.1997**
(21) Anmeldenummer: 96110569.9
(22) Anmeldetag: 28.06.1996
(51) Int. Cl.: G01R 19/165

(54) **Integrierte Komparatorschaltung**

(30) Priorität: 12.07.1995 DE 19525427
(71) Anmelder: SIEMENS AKTIENGESELLSCHAFT, 80333 München (DE)
(72) Erfinder: Tihanyi, Jenö, Dr. Ing., 85551 Kirchheim (DE)

(57) **Zusammenfassung**

Der Komparator enthält eine Eingangsstufe mit komplementären MOSFET (1, 2) und eine nachgeschaltete Inverterstufe mit zwei weiteren komplementären MOSFET (3, 4). Die Gateanschlüsse der komplementären MOSFET (1, 2) der Eingangsstufe sind mit dem Verbindungspunkt (10) der MOSFET der Eingangsstufe und mit den Gateanschlüssen der komplementären MOSFET (3, 4) der Inverterstufe verbunden. Das Eingangssignal (Uₑ) wird zwischen die Reihenschaltung der MOSFET (1, 2) und einen Anschluß (5; 15) für eine Versorgungsspannung angelegt. Zwischen diesen Anschluß (5; 15) und der Reihenschaltung der MOSFET (3, 4) der Inverterstufe ist eine Referenzspannung (V_{R}) angelegt, die die Schaltschwelle der Komparatorschaltung bestimmt. Die MOSFET (1, 2, 3, 4) gleichen Kanaltyps sind jeweils gleich aufgebaut.

**Vorteile:**

Einfacher Schaltungsaufbau, temperaturunempfindlich

## Beschreibung

Die Erfindung bezieht sich auf eine integrierte Komparatorschaltung mit einem ersten Anschluß und einem zweiten Anschluß für eine Betriebsspannung und den Merkmalen:
(a) eine Eingangsstufe mit zwei komplementären MOSFET, welche mit ihren Hauptstrompfaden in Reihe geschaltet sind und einen gemeinsamen Verbindungspunkt aufweisen;
(b) die Reihenschaltung der MOSFET ist zwichen den ersten Anschluß und einen dritten Anschluß geschaltet,
(c) die Gateanschlüsse der beiden MOSFET sind and en gemeinsamen Verbindungspunkt geschaltet;
(d) eine Inverterstufe mit zwei komplementären MOSFET, welche mit ihren Hauptstrompfaden in Reihe geschaltet sind und einen gemeinsamen Verbindungspunkt aufweisen, der einen Ausgangsanschluß bildet;
(e) die Gateanschlüsse der beiden MOSFET sind an den gemeinsamen Verbindungspunkt der Eingansstufe geschaltet;
(f) ein Eingangssignal Uₑ der Komparatorschaltung ist zum Anschluß zwischen den zweiten Anschluß und dem dritten Anschluß vorgesehen.

Eine solche Komparatorschaltung ist z. B. in der DE 41 38 860 C1 beschrieben. Die Reihenschaltung der MOSFET der Inverterstufe ist zwischen die beiden Anschlüsse für die Betriebsspannung geschaltet. Das Spannungsteilerverhältnis der beiden komplementären MOSFET der Eingangsstufe ist bei dieser bekannten Komparatorschaltung so gewählt, daß die nachfolgende Inverterstufe bei Uₑ = 0 Volt mit ihren beiden komplementären MOSFET einen H-Pegel an ihrem Ausgang bereitstellt. Wird dagegen eine positive Spannung Uₑ an die Eingangsanschlüsse der Eingangsstufe der Komparatorschaltung angelegt, so verschiebt sich das Potential am Ausgang der Eingangsstufe in Richtung höherer Werte, wodurch die Ausgangsspannung Uₑ der Inverterstufe auf L-Pegel sinkt. Um eine definierte Ansprechschwelle dieser bekannten Komparatorschaltung für Uₑ > 0 Volt einzustellen, müssen die Übertragungs-Kennlinien desjenigen MOSFET der Eingangsstufe, welcher mit dem Eingangssignal beaufschlagt wird, und der MOSFET des gleichen Kanaltyps der Inverterstufe unterschiedlich gewählt werden. Diese MOSFET müssen deshalb zwangsweise unterschiedlich aufgebaut sein. Darüber hinaus bedingt ein solcher unterschiedlicher Aufbau der MOSFET eine erhöhte Temperatur- und Störspannungsempfindlichkeit.

Die bekannte Komparatorschaltung hat jedoch den entscheidenden Vorteil, daß sie keine Stromquellen und Widerstände benötigt und ausschließlich aus MOSFET besteht.

Komparatorschaltungen werden im allgemeinen dazu eingesetzt, eine Spannung, bezogen auf ein Bezugspotential, zu erfassen. Sobald die zu erfassende Spannung einen vorgegebenen Wert, den sogenannten Schwellwert, überschreitet, ist am Ausgang des Komparators ein Signal abgreifbar, das das Überschreiten des Schwellwertes anzeigt. Wird dagegen der Schwellwert von der Eingangsspannung am Komparator nicht erreicht, gibt der Ausgang des Komparators ein anderes Ausgangssignal ab, so daß das Unterschreiten des Schwellwertes ebenfalls eindeutig am Ausgang des Komparators signalisiert wird. Bei Komparatorschaltungen ist es häufig notwendig, auch kleine Spannungen im Millivoltbereich zu erfassen, obwohl am Meßpunkt auch sehr große Spannungen anstehen können. Dies ist insbesondere bei selbstisolierenden Leistungs-ICs der Fall.

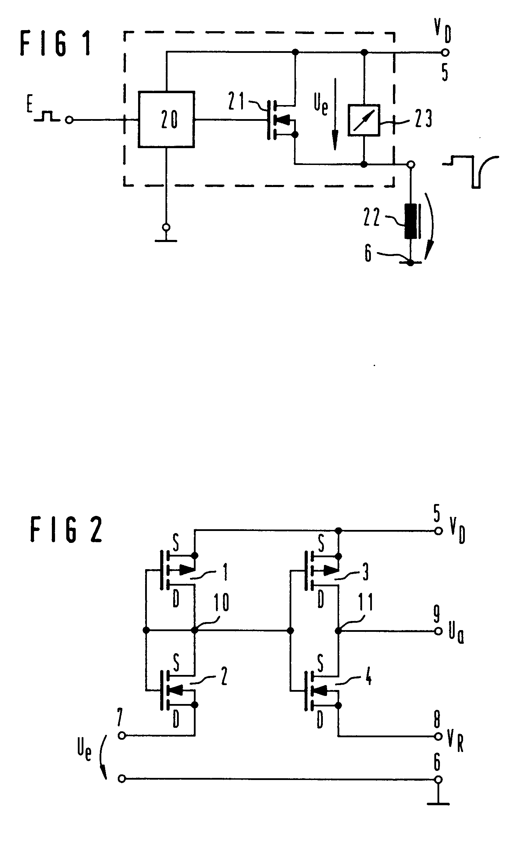

Als Beispiel ist in Figur 1 das Prinzipschaltbild eines Leistungsschalters gezeigt, bei der ein Leistungsschaltelement, hier ein Leistungs-MOSFET 21 in Reihe zu einer induktiven Last 22 geschaltet ist. Die Reihenschaltung aus Leistungs-MOSFET und induktiver Last 22 liegt zwischen den Anschlüssen 5, 6 einer Betriebsspannung, bei welcher das positive Potential an den Anschluß 5 und ein Null-Potential an den Anschluß 6 gelegt ist. Dem Steueranschluß des Leistungs-MOSFET 21 wird über eine Steuerschaltung 20, welche mit ihren Versorgungsspannungsklemmen an die Anschlüsse 5 und 6 geschaltet ist, mit Eingangssteuerimpulsen E angesteuert. Zur Messung des Spannungsabfalles entlang des Hauptstrompfades des Leistungs-MOSFET ist eine Komparatorschaltung 23 parallel zum Hauptstrompfad des Leistungs-MOSFET 21 geschaltet. Die Komparatorschaltung 23 muß einerseits in der Lage sein sehr kleine Spannungen zu erfassen, wenn der Leistungs-MOSFET 21 eingeschaltet ist, da Uₑ im eingeschalteten Zustand im Milli-Volt-Bereich liegt. Aufgrund der induktiven Last 22 erreicht die Spannung Uₑ dagegen beim Abschalten einen sehr hohen negativen Wert. Deshalb ist es notwendig, daß die Komparatorschaltung 23 auch diese hohe Spannung während des Abschaltvorganges des Leistungs-MOSFET aushält, ohne Schaden zu nehmen.

Zur Lösung dieses Problems werden bisher bekannte CMOS-Komparatorschaltungen mit Schutzbauelementen am Eingang der Komparatorschaltung verwendet.

Ziel der Erfindung ist es, eine integrierte Komparatorschaltung gemäß der eingangs genannten Gattung anzugeben, die im Vergleich zu den bisher bekannten Komparatorschaltungen einfacher aufgebaut ist, sich durch eine hohe Temperaturunempfindlichkeit auszeichnet, sehr kleine Spannungen erfassen kann und trotzdem eine hohe Spannungsfestigkeit aufweist.

Dieses Ziel wird bei der eingangs genannten Komparatorschaltung durch folgende weitere Merkmale erreicht:
(g) die Reihenschaltung der MOSFET der Inverterstufe ist zwischen den ersten Anschluß und einen vierten Anschluß geschaltet;
(h) der vierte Anschluß ist auf ein die Schaltschwelle der Komparatorschaltung bestimmendes Referenzpotential V_{R} gelegt, dessen Niveau zwischen den Potentialen des ersten Anschlusses und des zweiten Anschlusses liegt;
(i) die MOSFET jeweils gleichen Kanaltyps sind gleich ausgebildet.

Weiterbildungen der Erfindung sind Gegenstand der Unteransprüche.

Die Erfindung wird anhand von bevorzugten Ausführungsbeispielen im Zusammenhang mit weiteren Figuren näher erläutert. Es zeigen:
- Fig. 1: ein Blockschaltbild einer bekannten und eingangs bereits beschriebenen Leistungsschalteinrichtung,
- Fig. 2: eine erste Schaltungsanordnung einer integrierten Komparatorschaltung nach der Erfindung,
- Fig. 3: ein Strom- und Spannungsdiagramm zur Schaltungsanordnung von Fig. 2,
- Fig. 4: eine Inverterstufe mit komplementären MOSFET, welche ausgangsseitig an die integrierte Komparatorschaltung gemäß Fig. 2 schaltbar ist,
- Fig. 5: eine zweite Schaltungsanordnung einer integrierten Komparatorschaltung nach der Erfindung,
- Fig. 6: ein Strom- und Spannungsdiagramm zur Schaltungsanordnung gemäß Fig. 5,
- Fig. 7: eine schematische Darstellung eines hochvolttauglichen p-Kanals-MOSFET zum Einsatz in der Schaltungsanordnung von Fig. 5.

In den nachfolgenden Figuren bezeichnen, sofern nicht anders angegeben, gleiche Bezugszeichen gleiche Teile mit gleicher Bedeutung.

Die integrierte Komparatorschaltung gemäß Figur 2 enthält eine Eingangsstufe mit einem p-Kanal-MOSFET 1 und einem n-Kanal-MOSFET 2. Beide MOSFET 1, 2 sind mit ihren Hauptstrompfaden in Reihe geschaltet und weisen einen gemeinsamen Verbindungspunkt 10 auf. Ein erster Anschluß 5 für ein positives Potential V_{D} einer Betriebsspannung ist mit dem Sourceanschluß des p-Kanal-MOSFET 1 in Verbindung. Ein zweiter Anschluß 6 für die Betriebsspannung ist auf Bezugspotential, hier Null-Potential, gelegt. Die Gateanschlüsse der MOSFET 1, 2 sind an den Verbindungspunkt 10 geschaltet. Der nicht an den Verbindungspunkt 10 angelegte Anschluß des n-Kanal-MOSFET 2 ist mit einem dritten Anschluß 7 verbunden. Zwischen den zweiten Anschluß 6 und den dritten Anschluß 7 ist die zu erfassende Eingangsspannung Uₑ anzulegen. Der Verbindungspunkt 10 ist mit den Gateanschlüssen des p-Kanal-MOSFET 3 und n-Kanal-MOSFET 4 der Inverterstufe verbunden. Die Hauptstrompfade dieser MOSFET 3, 4 sind in Reihe geschaltet und weisen ebenfalls einen gemeinsamen Verbindungspunkt 11 auf, der zugleich einen Ausgangsanschluß 9 der Komparatorschaltung bildet. Der Sourceanschluß des p-Kanal-MOSFET 3 ist an den ersten Anschluß 5 gelegt. Der nicht an den gemeinsamen Verbindungspunkt 11 geschaltete Anschluß des n-Kanal-MOSFET 4 ist an einen vierten Anschluß 8 geschaltet, an den eine Referenzspannung V_{R} angelegt wird. Diese Referenzspannung V_{R} bestimmt in einer noch zu erläuternden Weise die Schaltschwelle der Komparatorschaltung und liegt mit ihrem Spannungswert zwischen den Potentialen des ersten Anschlusses 5 und des zweiten Anschlusses 6.

Obwohl es prinzipiell möglich ist, die beiden n-Kanal-MOSFET 2 und 4 jeweils mit ihren Drainanschlüssen an die entsprechenden Verbindungspunkte 10 bzw. 11 zu schalten, hat es sich aufgrund der damit erreichbaren hohen Spannungsfestigkeit als vorteilhaft erwiesen, hochvolttaugliche MOSFET einzusetzen, bei welchen jeweils der vorhandene Drainanschluß als Sourceanschluß und der vorhandene Sourceanschluß als Drainanschluß dient. Bei der Verwendung solcher hochvolttauglicher MOSFET sind die jeweiligen Sourceanschlüsse an die Verbindungspunkte 10 bzw. 11 der Komparatorschaltung zu legen. Folglich wird der Drainanschluß des hochvolttauglichen MOSFET 2 an den dritten Anschluß 7 und der Drainanschluß des hochvolttauglichen MOSFET 4 an den vierten Anschluß 8 geschaltet. Dies ist in Figur 2 dargestellt. Unter hochvolttauglichen MOSFET sind in diesem Zusammenhang solche MOSFET zu verstehen, die eine so hohe Spannungsfestigkeit aufweisen, wie die entsprechenden Leistungs-MOSFET, denen die Komparatorschaltung parallel geschaltet ist (vgl. Fig. 1).

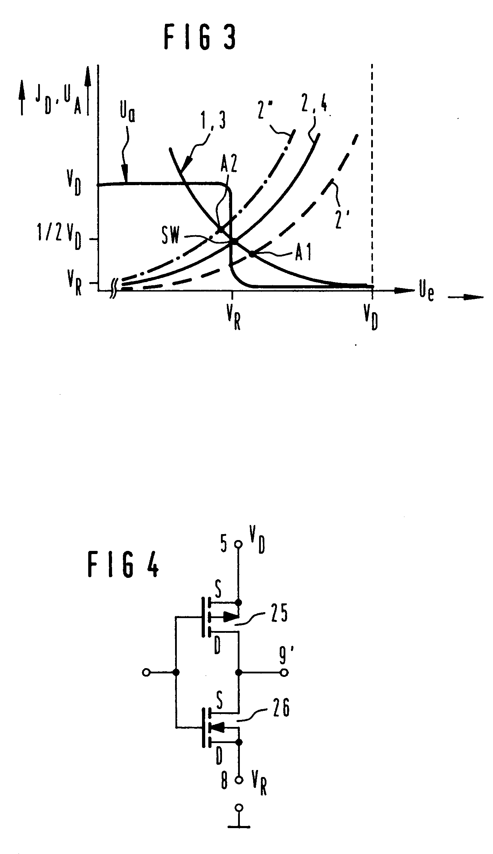

Die Wirkungsweise der in Fig. 2 dargestellten integrierten Komparatorschaltung stellt sich unter Bezugnahme auf das Strom- und Spannungsdiagramm gemäß Fig. 3 wie folgt dar. Hierbei wird davon ausgegangen, daß die MOSFET 1, 2, 3, 4 jeweils gleichen Kanaltyps erfindungsgemäß gleich ausgebildet sind. Dies hat den Vorteil einer einfachen Herstellungstechnologie. Die p-Kanal-MOSFET 1, 3 können von beliebiger Art sein, auch einfache Logiktransistoren sind möglich. Zweckmäßig ist es, die MOSFET 1, 2, 3, 4 mit möglichst minimalen Abmessungen zu verwenden, damit die gesamte Stromaufnahme der Komparatorschaltung nicht zu groß wird.

Voraussetzungsgemäß sind die Übertragungs-Kennlinien der MOSFET 1 und 3 sowie 2 und 4 jeweils gleich. Die Übertragungs-Kennlinien (U_{GS}/I_{D} für die MOSFET 1 und 3 bzw. U_{GD}/I_{S} für die vorzugsweise "verkehrt gepolten" hochvolttauglichen MOSFET 2 und 4) sind in Fig. 3 ebenfalls mit den Bezugszeichen 1, 2, 3 und 4 bezeichnet. Die Schaltschwelle SW der Inverterstufe ist durch den Schnittpunkt der Übertragungs-Kennlinien der MOSFET 3 und 4 gegeben. Die Schaltschwelle SW entspricht dem Potential der Referenzspannung V_{R} an der Klemme 8.

Wenn das Eingangssignal Uₑ zwischen den Klemmen 6 und 7 der Komparatorschaltung gleich der Referenzspannung V_{R} zwischen den Klemmen 6 und 8 ist, so befindet sich der Verbindungspunkt 10 und der Verbindungspunkt 11 der Komparatorspannung auf gleichen Potential, welches von der Dimensionierung der einzelnen MOSFET 1, 2, 3 und 4 abhängig ist. Im Ausführungsbeispiel von Fig. 3 ist angenommen, daß die Verbindungspunkte 10 und 11 auf etwa der halben Betriebsspannung, also 1/2 V_{D}, liegen.

Ist dagegen die Eingangsspannung Uₑ größer als die Referenzspannung V_{R}, so bleibt zwar die Übertragungslinie der MOSFET 1,3 und 4 unverändert, die Übertragungs-Kennlinie des MOSFET 2 verschiebt sich jedoch nach rechts, was durch die mit dem Bezugszeichen 2' markierte Kennlinie deutlich wird. Das Potential am Verbindungspunkt 10 verschiebt sich in Richtung V_{D}. Hierdurch wird der MOSFET 4 stärker leitend, die Leitfähigkeit des MOSFET 3 nimmt dagegen ab. Die Ausgangsspannung Uₐ sinkt damit auf das Potential V_{R} ab. Ist dagegen die Eingangsspannung Uₑ kleiner als die Referenzspannung V_{R}, stellt sich die in Fig. 3 mit dem Bezugszeichen 2'' gezeichnete Übertragungs-Kennlinie ein, die zu den Übertragungs-Kennlinien 2 und 2' nach links verschoben ist. Für diesen Fall stellt sich der Arbeitspunkt A2, der durch den Schnittpunkt der Übertragungskennlinie 2'' mit der Übertragungskennlinie 1, 3 festgelegt ist, ein. Die Ausgangsspannung Uₐ ist in diesem Fall das Spannungspotenntial V_{D} an der Klemme 5 der Komparatorschaltung.

Die in Fig. 2 dargestellte Komparatorschaltung erlaubt es in einfacher Weise die Schaltschwelle SW anhand der Wahl des Referenzpotentials V_{R} an der Klemme 8 festzulegen. Wird das Referenzpotential V_{R} sehr klein gewählt, beispielsweise 0,1 Volt, so kann mit dieser Schaltungsanordnung eine Komparatorschaltung mit einer Schaltschwelle SW bei 0,1 Volt realisiert werden. Die Komparatorschaltung ist wegen der Verwendung identischer MOSFET gleichen Kanaltyps temperaturunabhängig und auch unempfindlich gegenüber Technologieschwankungen.

In Fig. 4 ist eine weitere Inverterstufe dargestellt mit zwei komplementären MOSFET 25, 26, welche identisch zu den MOSFET 1 und 2 bzw. 3 und 4 der in Fig. 2 dargestellten Komparatorschaltung sind. Diese weitere Inverterstufe wird vorzugsweise ausgangsseitig an die Komparatorschaltung gemäß Fig. 2 geschaltet. Hierfür sind die Hauptstrompfade der beiden MOSFET 25, 26 zwischen die Anschlüsse 5 und 8 geschaltet. Die Gateanschlüsse dieser MOSFET 25, 26 sind mit dem Anschluß 9 von Fig. 2 zu verbinden und der Verbindungspunkt der beiden Hauptstrompfade der MOSFET 25, 26 bildet jetzt den Ausgangsanschluß 9' der Komparatorschaltung. Das Nachschalten dieser weiteren Inverterstufe von Fig. 4 an die Komparatorschaltung von Fig. 2 hat den Vorteil, daß das Ausgangssignal der Komparatorschaltung am Ausgangsanschluß 9' betragsmäßig der Abweichung der Eingangsspannung Uₑ von der Referenzspannung V_{R} entspricht. Überschreitet die Eingangsspannung Uₑ die Referenzspannung V_{R} ist am Ausgangsanschluß 9' ein "H"-Pegel abgreifbar, während beim Unterschreiten der Eingangsspannung Uₑ unter die Referenzspannung V_{R} der Ausgangsanschluß 9' auf "L"-Pegel liegt. Somit schlägt die Ausgangsspannung am Ausgangsanschluß 9 bzw. 9' aus, wenn die Eingangsspannung Uₑ von der Referenzspannung V_{R} abweicht. Diese Reaktion ist um so größer, je mehr Inverterstufen hintereinander geschaltet sind. Obwohl im Zusammenhang mit Fig. 2 und 4 lediglich von zwei hintereinander geschalteten Inverterstufen die Rede ist, können auch mehrere solcher Inverterstufen hintereinander zu schalten.

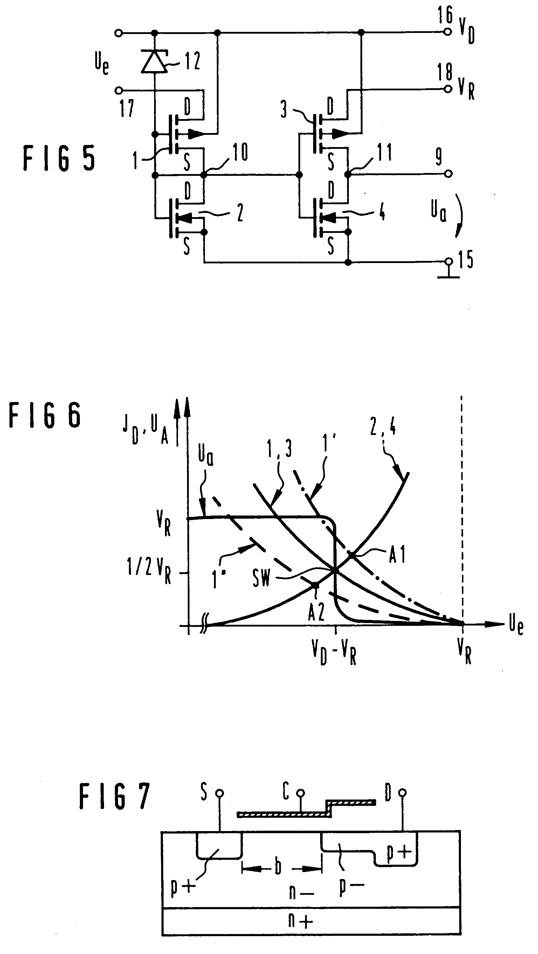

In Fig. 5 ist ein weiteres Ausführungsbeispiel einer Schaltungsanordnung für eine Komparatorschaltung nach der Erfindung dargestellt. Im Unterschied zu der Komparatorschaltung gemäß Fig. 2 eignet sich diese Komparatorschaltung zur Erfassung einer Eingangsspannung Uₑ bezogen auf ein positives Betriebsspannungspotential, hier die Betriebsspannung V_{D}, welche an einen zweiten Anschluß 16 gelegt ist. Der erste Anschluß 15 liegt auf niedrigerem Potential, hier Null-Potential. Die MOSFET 1, 2 und 3, 4 sind mit ihren Hauptstrompfaden wieder in Reihe geschaltet und weisen jeweils Verbindungspunkte 10, 11 auf. Der Hauptstrompfad des p-Kanal-MOSFET 1 liegt mit seinem einen Anschluß an einen dritten Anschluß 17 der Komparatorschaltung und mit seinem anderen Anschluß an dem Verbindungspunkt 10. Der Drainanschluß des n-Kanal-MOSFET 2 ist ebenfalls an diesen Verbindungspunkt 10 gelegt, während dessen Sourceanschluß an den ersten Anschluß 15 der Komparatorschaltung geschaltet ist. Die beiden Gateanschlüsse der MOSFET 1 und 2 sind an den Verbindungspunkt 10 geschaltet. Der Verbindungspunkt 10 ist, ähnlich wie in Fig. 2, wieder an die Gateanschlüsse der komplementären MOSFET 3, 4 geschaltet. Ein Anschluß des Hauptstrompfades des p-Kanal-MOSFET 3 ist an einen vierten Anschluß 18 der Komparatorschaltung gelegt, während der andere Anschluß dieses MOSFET 3 am Verbindungspunkt 11 geschaltet ist, der zugleich mit der Ausgangsklemme 9 in Verbindung steht. Der Drainanschluß des n-Kanal-MOSFET 4 ist an diesen Verbindungspunkt 11 geschaltet, während der Sourceanschluß an den ersten Anschluß 15 der Komparatorschaltung gelegt ist.

In dem Ausführungsbeispiel von Fig. 5 sind jetzt die MOSFET 1, 3 hochvolttauglich und mit ihren Drainanschlüssen und Sourceanschlüssen "verkehrt gepolt" in die Komparatorschaltung eingebaut. Hierfür ist der Drainanschluß der MOSFET 1 mit dem dritten Anschluß 17 und dessen Sourceanschluß an den Verbindungspunkt 10 geschaltet. Der hochvolttaugliche MOSFET 3 ist mit seinem Drainanschluß an den vierten Anschluß 18 und mit seinem Sourceanschluß an den Verbindungspunkt 11 geschaltet. Die Eingangsspannung Uₑ liegt zwischen dem zweiten Anschluß 16 und dem dritten Anschluß 17, während die Referenzspannung V_{R} zwischen dem zweiten Anschluß 16 und dem vierten Anschluß 18 anzulegen ist. Das Ausgangssignal Uₐ ist zwischen dem Anschluß 9 und 15 abgreifbar.

Die Funktionsweise der in Fig. 5 dargestellten Komparatorschaltung wird anhand des Strom-Spannungsdiagramms von Fig. 6 deutlich. Voraussetzungsgemäß sind die Übertragungs-Kennlinien der beiden MOSFET 1 und 3 und der beiden MOSFET 2 und 4 aufgrund des gleichen Aufbaus identisch. Dies wird in Fig. 6 anhand der mit dem Bezugszeichen 1, 3 bzw. 2, 4 gekennzeichneten Übertragungs-Kennlinien deutlich. Der Schnittpunkt dieser beiden Kennlinien legt wieder die Schaltschwelle SW der Komparatorschaltung fest. Ist die Eingangsspannung Uₑ gleich der Referenzspannung V_{R}, entspricht die Übertragungs-Kennlinie des MOSFET 1 der Übertragungs-Kennlinie des MOSFET 3. In diesem Fall befindet sich die Ausgangsspannung Uₐ auf ihrem Ruhewert, beispielsweise 1/2 V_{R}. Der Verbindungspunkt 10 liegt auf gleichem Potential. Es sei angenommen, daß im vorliegenden Fall die Betriebsspannung V_{D} mit 10 Volt und die Referenzspannung V_{R} bezogen auf Null-Potential 9,9 Volt beträgt. Die Spannung zwischen dem zweiten Anschluß 16 und dem vierten Anschluß 18 liegt somit auf 0,1 Volt. Solange die Eingangsspannung Uₑ gleich diesen 0,1 Volt ist, befindet sich die gesamte Komparatorschaltung in Ruhestellung. Wird die Eingangsspannung Uₑ zwischen den Anschlüssen 16 und 17 kleiner 0,1 Volt, erhöht sich das Potential am Anschluß 17. Damit erhöht sich auch das Potential am Verbindungspunkt 10, wodurch der MOSFET 4 stärker leitend wird und der MOSFET 3 sperrt. Die Übertragungs-Kennlinie des MOSFET 1 verschiebt sich gemäß der Darstellung von Fig. 6 nach rechts (vgl. die Übertragungs-Kennnlinie 1'). Es stellt sich der Arbeitspunkt A1 ein. Die Ausgangsspannung Uₐ entspricht "L"-Pegel. Wird dagegen die Eingangsspannung Uₑ, bezogen auf V_{D}, größer, hier also größer als 0,1 Volt, sinkt das Potential am Verbindungspunkt 10 und der MOSFET 3 wird stärker leitend, während der MOSFET 4 sperrt. Am Ausgangsanschluß 9 ist die Referenzspannung V_{R} abgreifbar und damit "H"-Pegel (vgl. die Übertragungs-Kennlinie 1''). Es stellt sich der Arbeitspunkt A2 ein.

Zusätzlich ist in der Komparatorschaltung von Fig. 5 eine Zenerdiode 12 vorgesehen, die mit ihrem Katodenanschluß an den zweiten Anschluß 16 und mit ihrem Anodenanschluß an den Verbindungspunkt 10 geschaltet ist. Diese Zenerdiode 12 stellt sicher, daß die Eingangsspannung Uₑ beliebig große negative Spannungen bezogen auf V_{D} aufnehmen kann, da der MOSFET 1 gesperrt ist, wenn die Zenerspannung der Zenerdiode 12 von der eingangsspannung Uₑ überschritten ist. Im übrigen ist es auch bei der in Fig. 5 vorgestellten Schaltungsanordnung möglich, mehrere Inverterstufen, die identisch zu der aus den komplementären MOSFET 3 und 4 bestehenden Inverterstufe sind, nachzuschalten.

Im Zusammenhang mit Fig. 7 wird der Vollständigkeit halber das Schnittbild eines an sich bekannten, hochvolttauglichen p-Kanal-MOSFET dargestellt. Dieser MOSFET weist ein n--Substrat auf, das an seiner unteren Seite mit einer n⁺-Schicht für einen Rückseitenkontakt versehen ist. An diesen Rückseitenkontakt ist ein Substratanschluß des MOSFET gelegt. In der gegenüberliegenden Oberfläche des n--Substrates liegen zwei p-dotierte Wannen. Eine dieser Wannen weist eine p⁺-Dotierung auf und ist von einem Sourceanschluß kontaktiert. Beabstandet zu dieser p⁺-Wanne befindet sich eine weitere p-dotierte größere Wanne mit einem ähnlichen p⁺-dotierten Bereich, an welchen ein Drainanschluß angeschlossen ist. An diesen p⁺-dortierten Bereich schließt sich unmittelbar ein p--dotierter Bereich geringerer Tiefe in Richtung Sourceanschluß an. Die beiden p-dortierten Wangen sind zueinander um die Kanallänge l beabstandet. Über dem Kanal ist eine abgestufte Gateelektrode angeordnet, die mit einem Gateanschluß des MOSFET in Verbindung steht. Ein hochvolttauglicher n-Kanal-MOSFET ist ähnlich aufgebaut, weist jedoch jeweils anstelle der p-Dotierung eine n-Dotierung und umgekehrt auf.

## Patentansprüche

1. Integrierte Komparatorschaltung mit einem ersten Anschluß (5; 15) und einem zweiten Anschluß (6; 16) für eine Betriebsspannung und den Merkmalen:
(a) eine Eingangsstufe mit zwei komplementären MOSFET (1, 2), welche mit ihren Hauptstrompfaden in Reihe geschaltet sind und einen gemeinsamen Verbindungspunkt (10) aufweisen;
(b) die Reihenschaltung der MOSFET (1, 2) ist zwischen den ersten Anschluß (5; 15) und einen dritten Anschluß (7; 17) geschaltet;
(c) die Gateanschlüsse der beiden MOSFET (1, 2) sind an den gemeinsamen Verbindungspunkt (10) geschaltet;
(d) eine Inverterstufe mit zwei komplementären MOSFET (3, 4), welche mit ihren Hauptstrompfaden in Reihe geschaltet sind und einen gemeinsamen Verbindungspunkt (11) aufweisen, der einen Ausgangsanschluß (9) bildet;
(e) die Gateanschlüsse der beiden MOSFET (3, 4) sind an den gemeinsamen Verbindungspunkt (10) der Eingangsstufe geschaltet;
(f) ein Eingangssignal (Uₑ) der Komparatorschaltung ist zum Anschluß zwischen den zweiten Anschluß (6; 16) und dem dritten Anschluß (7; 17) vorgesehen,
gekennzeichnet durch die weiteren Merkmale:
(g) die Reihenschaltung der MOSFET (3, 4) der Inverterstufe ist zwischen den ersten Anschluß (5; 15) und einen vierten Anschluß (8; 18) geschaltet;
(h) der vierte Anschluß (8; 18) ist auf ein die Schaltschwelle der Komparatorschaltung bestimmendes Referenzpotential (V_{R}) gelegt, dessen Niveau zwischen den Potentialen des ersten Anschlusses (5; 15) und des zweiten Anschlusses (6; 16) liegt;
(i) die MOSFET (1, 2, 3, 4) jeweils gleichen Kanaltyps sind gleich ausgebildet.

2. Integrierte Komparatorschaltung nach Anspruch 1,
dadurch gekennzeichnet, daß der MOSFET (2; 1) des einen Kanaltyps der Eingangsstufe, welcher mit dem dritten Anschluß (7; 17) verbunden ist, und der MOSFET (4; 3) vom gleichen Kanaltyp der Inverterstufe hochvolttaugliche MOSFET sind, bei welchen jeweils der vorhandene Drainanschluß als Sourceanschluß und der vorhandene Sourceanschluß als Drainanschluß geschaltet sind.

3. Integrierte Komparatorschaltung nach Anspruch 1 oder 2,
dadurch gekennzeichnet, daß das Potential am ersten Anschluß (5) ein positives Spannungspotential und am zweiten Anschluß (6) ein niedrigeres Bezugspotential, insbesondere Nullpotential, angelegt ist.

4. Integrierte Komparatorschaltung nach Anspruche 1,
dadurch gekennzeichnet, daß am zweiten Anschluß (16) ein positives Spannungspotential und am ersten Anschluß (15) ein niedrigeres Bezugspotential, insbesondere Nullpotential, angelegt ist.

5. Integrierte Komparatorschaltung nach Anspruch 4, dadurch gekennzeichnet, daß zwischen den zweiten Anschluß (6; 16) und den Verbindungspunkt (10) der Eingangsstufe eine Zenerdiode (12) geschaltet ist.

6. Integrierte Komparatorschaltung nach einem der Ansprüche 1 bis 5,
dadurch gekennzeichnet, daß der Inverterstufe mindestens eine weitere Inverterstufe mit zu den MOSFET (3, 4) der ersten Inverterstufe gleichen komplementären MOSFET (25, 26) nachgeschaltet ist.

7. Integrierte Komparatorschaltung nach Anspruch 6,
dadurch gekennzeichnet, daß der ersten Inverterstufe mehrere gleichartige Inverterstufen nachgeschaltet sind.

8. Integrierte Komparatorschaltung nach einem der Ansprüche 1 bis 7,
dadurch gekennzeichnet, daß die an den ersten Anschluß (5; 15) geschalteten MOSFET (1; 2) Logiktransistoren sind.
